# EUROPEAN PATENT SPECIFICATION

(11) **EP 4 012 759 B1**
(45) Date of publication and mention of the grant of the patent: **22.11.2023**
(21) Application number: 20213165.2
(22) Date of filing: 10.12.2020
(51) Int. Cl.: H01L 23/00, H01L 23/049, H01L 23/16, H01L 25/07

(54) **POWER SEMICONDUCTOR MODULE, POWER SEMICONDUCTOR ASSEMBLY AND METHOD FOR PRODUCING A POWER SEMICONDUCTOR MODULE**
LEISTUNGSHALBLEITERMODUL, LEISTUNGSHALBLEITERANORDNUNG UND VERFAHREN ZUR HERSTELLUNG EINES LEISTUNGSHALBLEITERMODULS
MODULE SEMI-CONDUCTEUR DE PUISSANCE, ENSEMBLE SEMI-CONDUCTEUR DE PUISSANCE ET PROCÉDÉ DE FABRICATION D'UN MODULE SEMI-CONDUCTEUR DE PUISSANCE

(43) Date of publication of application: 15.06.2022
(73) Proprietor: Hitachi Energy Switzerland AG, 5400 Baden (CH)
(72) Inventor: DUGAL, Franc, 8121 Benglen (CH); PAQUES, Gontran, 5708 Birrwil (CH)
(74) Representative: Epping - Hermann - Fischer

(56) References cited:
- EP-A1- 1 263 045
- EP-A2- 0 067 575
- US-A1- 2009 021 916
- US-A1- 2009 039 498
- US-A1- 2010 302 741

## Description

The disclosure relates to a power semiconductor module, a power semiconductor assembly and a method for producing a power semiconductor module.

Document EP 1 263 045 A1 describes a stackable power semiconductor module comprising a submodule and a module frame, wherein the submodule comprises a semiconductor device, a press pin with a spring washer, a gate runner, and a housing, wherein inside and outside protrusions are arranged between the submodule housing and the frame, and wherein small pieces of elastic foam are disposed vertically between said protrusions.

Document US 2010/302741 A1 describes a power semiconductor module including a module housing and at least one substrate populated with at least one power semiconductor chip.

Document US 2009/039498 A1 describes a power semiconductor module including a module housing cover and a substrate on which a power semiconductor chip is arranged.

Electrical converters make use, for example, of several power semiconductor modules being stacked above one another, with the help of a mechanical clamping system. Different current ratings of the power semiconductor modules are obtained by paralleling different numbers of submodules. In this case, the submodules are inserted into a module frame of a power semiconductor module without being mechanically attached to it. This provides a degree of movement of the submodules within the module frame needed to distribute uniformly the clamping force, when the semiconductor modules are clamped into a stack. Unfortunately, too much movement of the submodules within the power semiconductor module, when it is not clamped into a stack, can lead to damage of the submodules.

The disclosure provides a power semiconductor module with an improved reliability, a power semiconductor assembly comprising such power semiconductor modules and a method for producing such a power semiconductor module.

The subject matter of the disclosure is defined by the independent claims. Further, exemplary embodiments are evident from the dependent claims and the following description.

A first aspect of the disclosure relates to a power semiconductor module. The term "power" here and in the following, for example, refers to power semiconductor modules, power semiconductor assemblies and/or power semiconductor devices configured for processing voltages and currents of more than 100 volts and/or more than 10 amperes, exemplarily, voltages of more than 1000 volts and currents of several 100 amperes.

The power semiconductor module has, for example, a main plain of extension. Lateral directions are aligned parallel to the main plain of extension, and a vertical direction is aligned perpendicular to the main plain of extension.

According to the claimed invention, the power semiconductor module comprises at least one submodule.

The power semiconductor module comprises, for example, a plurality of submodules. E.g., the power semiconductor module comprises four or six submodules. The submodules are arranged in lateral directions next to one another. Further, the submodules are spaced apart from one another in lateral directions. For example, the submodules are arranged at grid points of a first regular grid. This is to say that the submodules are arranged in a matrix, for example, along rows and columns. The first regular grid is, for example, a triangular grid, a square grid or a hexagonal grid.

According to the claimed invention, the at least one submodule of the power semiconductor module includes at least one power semiconductor device being configured to be connected to at least one press pin and at least one gate pin.

The at least one power semiconductor device is based, for example, on silicon or silicon carbide. The power semiconductor device is formed, for example, as a power transistor like insulated gate bipolar transistor, abbreviated as IGBT, a reverse-conducting insulated gate bipolar transistor, abbreviated as reverse-conducting IGBT, a bi-mode insulated gate transistor, abbreviated as BIGT, or a diode.

The at least one submodule comprises, for example, a plurality of power semiconductor devices. The power semiconductor devices are, for example, spaced apart from one another in lateral directions within the submodule. For example, the power semiconductor devices are arranged at grid points of a second regular grid. This is to say that the power semiconductor devices are arranged in a matrix, for example, along rows and columns. The second regular grid is, for example, a triangular grid, a square grid or a hexagonal grid.

The semiconductor devices are interconnected with one another electrically conductively in parallel. Furthermore, the press pin and the gate pin are electrically conductively connected to the power semiconductor device. Exemplarily, exactly one press pin and exactly one gate pin are connected electrically conductively to exactly one power semiconductor device.

According to the claimed invention, the at least one submodule of the power semiconductor module includes a housing surrounding the at least one power semiconductor device in lateral directions. For example, the housing completely surrounds the power semiconductor device in lateral directions.

If the submodule comprises the plurality of power semiconductor devices, the housing completely surrounds all the power semiconductor devices, all the press pins and all the gate pins in lateral directions. This is to say that the housing encloses all the power semiconductor devices, all the press pins and all the gate pins in lateral directions.

According to the claimed invention, the power semiconductor module comprises a module frame laterally surrounding the at least one submodule in lateral directions. According to the claimed invention, the module frame completely surrounds the submodule in lateral directions.

If the power semiconductor module comprises the plurality of submodules, each submodule is surrounded completely in lateral directions by the module frame. This is to say that the module frame is arranged between every directly adjacent submodule.

According to the claimed power semiconductor module, at least one elastic element is arranged between the module frame and the housing. The elastic element is, for example, configured to reduce a freedom of movement of the submodule within the module frame. Exemplarily, the freedom of movement is reduced when the power semiconductor module is in an unclamped situation. E.g., an elasticity of the elastic element is lower than an elasticity of the module frame and the housing.

For example, an elasticity of the elastic element is represented by the Young modulus. The Young modulus is, for example, at least 0.01 MPa and at most 1 GPa, e.g. at least 1 MPa and at most 500 MPa.

In summary, such a power semiconductor module can provide, inter alia, the following advantages. Advantageously, the use of an elastic element prevents a damage of the power semiconductor module or power semiconductor module failure during handling or transportation.

According to the claimed invention, the at least one power semiconductor device is connected to at least one press pin and at least one gate pin and the housing laterally surrounds the at least one press pin and at least one gate pin in lateral directions.

According to an example not falling within the scope of the claimed invention, the elastic element surrounds the housing solely in regions in lateral directions According the claimed invention, the elastic element completely surrounds the housing in lateral directions. For example, if the elastic element surrounds the housing solely in regions in lateral directions the elastic element is arranged between the module frame and the housing discontinuously. Advantageously, due to such a discontinuous elastic element which is helpful for understanding but does not form part of the claimed invention, less material of the elastic element is used in comparison with an elastic element completely surrounding the housing. Such a power semiconductor module is, exemplarily, cost effective.

According to the claimed invention, the elastic element encloses the power semiconductor module in lateral directions completely. The elastic element is arranged between the module frame and the housing continuously. In this case, the elastic element is configured advantageously as a seal.

For example, the elastic element is configured to protect the semiconductor devices from external chemical contaminations, i.e. humidity. Further, such an elastic element configured as a seal also protects an outside of the power semiconductor module, in the case a power semiconductor power device fails and produces a hot plasma.

According to the claimed invention, the module frame comprises a first protrusion on an inner side surface facing the at least one submodule. For example, the inner side surface of the module frame extends in a vertical direction facing the housing. A first bar structure is, for example, arranged on the inner side surface of the module frame. Exemplarily, the first bar structure surrounds the submodule in lateral directions completely. The first protrusion is formed, e.g., by the first bar structure. For example, the first protrusion and the module frame are formed in one piece.

In this embodiment, the first protrusion, e.g., the first bar structure, comprises a top surface and a bottom surface being located opposite to one another, wherein the top surface and the bottom surface are interconnected by a side surface. For example, the bottom surface of the first protrusion terminates flush with a bottom surface of the module frame. Further, the side surface of the first protrusion faces the housing. For example, the inner side surface of the module frame, the top surface of the first protrusion and the side surface of the first protrusion form a step profile in a cross sectional view in vertical direction.

According to the claimed invention, the elastic element is arranged on the first protrusion. For example, the elastic element is arranged on the top surface of the first protrusion. The elastic element covers the top surface of the first protrusion, for example, completely. Alternatively, the top surface of the first protrusion is, for example, free of the elastic element at least in some areas.

In addition, the elastic element is arranged on the inner side surface of the module frame at least in places, for example. For example, the inner side surface of the module frame is in large parts free of the elastic element. In large parts free means here that at least 70%, for example, at least 90%, of the inner side surface of the module frame is free of the elastic element.

According to the claimed invention, the housing comprises a second protrusion on an outer side surface facing the module frame. A second bar structure is, for example, arranged on the outer side surface of the housing. Exemplarily, the second bar structure surrounds the power semiconductor device in lateral directions completely. The second protrusion is formed, e.g., by the second bar structure. For example, the second protrusion and the housing are formed in one piece.

In this embodiment, the second protrusion, e.g., the second bar structure, comprises a top surface and a bottom surface being located opposite to one another, wherein the top surface and the bottom surface are interconnected by a side surface. For example, the side surface of the second protrusion faces the module frame.

According to the claimed invention, the first protrusion and the second protrusion are not in direct contact with one another. Further, the first protrusion and the second protrusion are overlapping at least in some areas with one another in plan view of the power semiconductor module. For example, the bottom surface of the second protrusion is located opposite the top surface of the first protrusion.

According to the claimed invention, the second protrusion is arranged on the elastic element. For example, the elastic element is arranged on the bottom surface of the second protrusion. The elastic element covers the bottom surface of the second protrusion, for example, completely. Alternatively, the bottom surface of the second protrusion is, for example, free of the elastic element at least in some areas.

In examples not forming part of the claimed invention, but helpful for understanding, the elastic element is arranged on the outer side surface of the housing at least in places. For example, the outer side surface of the housing is in large parts free of the elastic element. In large parts free means here that at least 70%, for example, at least 90%, of the outer side surface of the housing is free of the elastic element.

According to at least one embodiment, the power semiconductor module comprises at least two submodules.

According to at least one embodiment of the power semiconductor module, the module frame comprises at least two openings being spaced apart from one another in lateral directions. The openings penetrate the module frame, for example, completely. Each opening has a two dimensional extension in lateral directions being slightly bigger than a two dimensional extension in lateral directions of each housing, for example. Slightly bigger means here that the two dimensional extension in lateral directions of each opening is, for example, 0.1 mm or 0.5 mm, bigger than the two dimensional extension in lateral directions of each housing.

If the power semiconductor module comprises at least two submodules, exemplarily, the plurality of submodules, the openings can be arranged at grid points of the first grid.

According to at least one embodiment of the power semiconductor module, each submodule is arranged in one of the at least two openings. For example, exactly one submodule is arranged in exactly one opening.

According to the claimed invention, the at least one press pin comprises an upper part and a lower part, wherein the lower part is in direct contact with the at least one power semiconductor device. The press pin comprises, a spring washer pack. The spring washer pack is configured to apply a force between the upper part and the lower part, pushing them in opposite directions in the vertical direction. This is to say that the upper part and the lower part are movable relative to one another along the vertical direction due to the spring washer pack.

Further, the upper part and the lower part are, for example, electrically conductively interconnected.

For example, the elasticity of the elastic element is higher than an elasticity of the whole spring washer pack in vertical direction. Thus, solely the spring washer pack is mainly compressed when clamping the power semiconductor module.

According to at least one embodiment of the power semiconductor module, an emitter cover is arranged on the upper part of the at least one press pin and the module frame. For example, the emitter cover is arranged in direct contact to the module frame and/or the upper part of the press pin. For example, the spring washer pack is configured to push the upper part to the emitter cover, such that an electrically conductive connection is established between the upper part and the emitter cover. The emitter cover is, for example, electrically conductive.

According to at least one embodiment of the power module, a base plate is arranged on the at least one power semiconductor device and the housing, wherein the base plate is in direct contact with the at least one power semiconductor device. In addition, the base plate is arranged in direct contact to the housing, for example. The base plate is, for example, electrically conductive.

According to at least one embodiment of the power module, the elastic element is a foam. For example, the foam is configured to be electrically insulating. Exemplarily, the foam is a polymeric foam.

According to at least one embodiment of the power module, the elastic element is partially compressed by the housing.

Advantageously, due to the elastic element the housing and the module frame are not in direct contact due to the elastic element. Therefore, besides the frame and the housing, the elastic element is in addition arranged between the emitter cover and the base plate. Advantageously, such an elastic element further increases an electrical insulation between the emitter cover and the base plate.

A second aspect of the disclosure relates to a power semiconductor assembly. The power semiconductor assembly comprises at least two power semiconductor modules described herein above. All features disclosed in connection with the power module are therefore also disclosed in connection with the method and vice versa.

According to the embodiment of the power semiconductor assembly, the at least two power semiconductor modules are stacked above one another. For example, the at least two power semiconductor modules are stacked in vertical direction and clamped against one another in vertical direction. Through the clamping, the press pins are pressed together in the vertical direction such that an electrically conductive connection between the lower part and the semiconductor device and the upper part and the emitter cover is established reliably.

A third aspect of the disclosure relates to a method for producing a power semiconductor module. Preferably the method produces a power semiconductor module described herein above. All features disclosed in connection with the power semiconductor module are therefore also disclosed in connection with the method and vice versa.

According to the embodiment, the method comprises providing at least one submodule, which includes at least one power semiconductor device configured to be contacted to at least one press pin and at least one gate pin, and a housing laterally surrounding the at least one power semiconductor device in lateral directions.

According to the claimed invention, the method comprises applying an elastic element on the module fra in the at least one opening. For example, the foam is applied on the top surface of the first protrusion. In addition, the foam is applied, for example, on the inner side surface of the module frame.

According to the claimed invention, the method comprises inserting the at least one submodule in the at least one opening of the module frame on the elastic element.

According to at least one embodiment, the method comprises attaching the elastic element to the module frame by a first adhesive. In this embodiment, a first adhesive is applied to the module frame before the application the foam. For example, the first adhesive is applied on the top surface of the first protrusion. In addition, the first adhesive is applied, for example, on the inner side surface of the module frame.

According to at least one embodiment, the method comprises attaching the at least one submodule to the elastic element by a second adhesive. For example, a second adhesive is applied to the housing, e.g., to the second protrusion. The application of the second adhesive can take place before or after the elastic element is applied to the module frame.

According to at least one embodiment, the method comprises applying the elastic element directly to the module frame. The elastic element is configured to adhere on the module frame, for example, during the application of the elastic element. In this embodiment, the power semiconductor module, e.g., the submodule, are free of an adhesive.

The subject matter of the disclosure will be explained in more detail in the following with reference to exemplary embodiments, which are illustrated in the attached drawings.
Figure 1 schematically shows a side view on a power semiconductor module according to an exemplary embodiment of the disclosure.
Figure 2 schematically shows a module frame in plan view of a power semiconductor module according to an exemplary embodiment, not falling under the claimed invention but helpful for understanding.
Figure 3 schematically shows an enlarged part of the side view of Figure 1.

The reference symbols used in the drawings, and their meanings, are listed in summary form in the list of reference symbols. In principle, identical parts are provided with the same reference symbols in the figures.

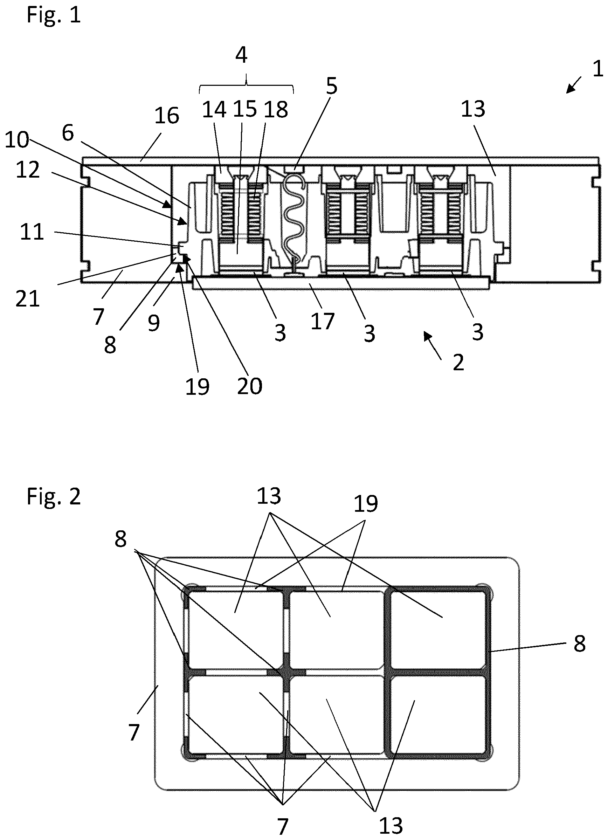

The power semiconductor module 1 shown in Figure 1 comprises a module frame 7 and a submodule 2. The module frame 7 has an opening 13, in which the submodule 2 is arranged.

The submodule 2 comprises three power semiconductor devices 3 being arranged on a base plate 17. The power semiconductor devices 3 are arranged spaced apart from one another in lateral directions. Each power semiconductor device 3 is electrically conductively connected to the base plate 17.

Each power semiconductor device 3 has a top surface facing away from the base plate 17.

Further, each power semiconductor device 3 is connected to a press pin 4 via the top surface of the power semiconductor device 3. Each press pins 4 comprises an upper part 14 and a lower part 15. Each lower part 15 is in direct contact with one of the top surfaces of the power semiconductor devices 3. The upper parts 14 are arranged on an emitter cover 16. This is to say that the press pin 4 is arranged between the emitter cover 16 and the base plate 17. Further, the upper part 14 and the lower part 15 are electrically conductively interconnected.

In addition, the press pin 4 comprises a spring washer pack 18 being arranged between the upper part 14 and the lower part 15. The spring washer pack 18 is configured to apply a force between the upper part 14 and the lower part 15, pushing them in opposite directions in vertical direction.

Adjacent to each press pin 4, a gate pin 5 is arranged between the emitter cover 16 and the base plate 17. Each gate pin 5 is electrically conductively connected to one of the power semiconductor devices 3.

If the power semiconductor devices 3 are, for example, formed of IGBTs, a contact between one of the lower parts 15 and one of the power semiconductor devices 3 forms an emitter contact. Further, a contact between the base plate 17 and one of the power semiconductor devices 3 forms a collector contact and a contact between one of the gate pins 5 and one of the power semiconductor devices 3 forms a gate contact. Further, the gate pin 5 is not in electric contact with the emitter cover 16.

The base plate 17 is formed from an electrically conductive material, such that the base plate 17 interconnects bottom surfaces of the semiconductor devices 3 electrically conductively with one another. Furthermore, the emitter cover 16 is formed from an electrically conductive material, such that the emitter cover 16 interconnects the upper parts 14 of the press pins 4 electrically conductively with one another.

The submodule 2 comprises a housing 6, which surrounds the power semiconductor devices 3, the press pins 4 and the gate pins 5 in lateral directions. The housing 6 is formed of an electrically insulating material.

The base plate 17 is arranged on the housing 6 and the base plate 17 is in direct contact with the housing 6. Further, the base plate 17 does not protrude beyond the housing 6 in lateral directions. The emitter cover 16 is arranged on the module frame 7. Further, the emitter cover 16 protrudes beyond the submodule 2 in lateral directions.

The module frame 7 has an inner side surface 10 facing the submodule 2, e.g., the housing 6. Further, the module frame 7 comprises a first protrusion 9 on the inner side surface 10. The first protrusion 9 and the module frame 7 are formed from a single piece. The module frame 7 with the first protrusion 9 has a step profile in a cross sectional view in vertical direction. Exemplarily, the inner side surface 10 of the module frame 7, a top surface of the first protrusion 19 and a side surface of the first protrusion 9 form the step profile.

In addition, the housing 6 has an outer side surface 12 facing the module frame 7. Further, the housing 6 comprises a second protrusion 11 on the outer side surface 12. The second protrusion 11 and the housing 6 are formed from a single piece. The second protrusion 11 comprises a top surface and a bottom surface of the second protrusion 20 opposite the top surface. The top surface of the second protrusion and the bottom surface of the second protrusion 20 are interconnected by a side surface.

The first protrusion 9 and the second protrusion 11 are not in direct contact with one another. Rather, the second protrusion 11 is arranged in vertical direction above the first protrusion 9. This is to say that the bottom surface of the second protrusion 20 and the top surface of the first protrusion 19 are facing one another but are not in direct contact with one another. Further, the first protrusion 9 and the second protrusion 11 are overlapping in places in plan view.

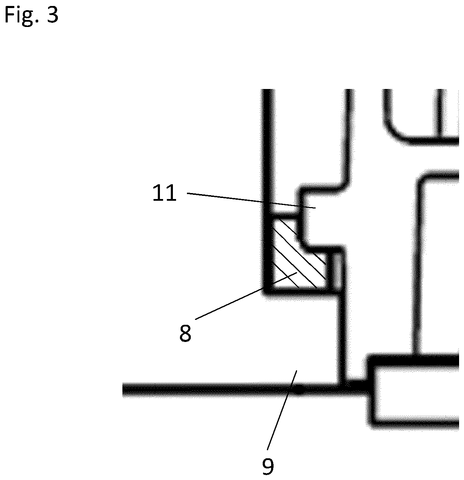

In other words, there is a gap 21 between surfaces of the first protrusion 9 and surfaces of the second protrusion 11, which face one another. Within this gap 21, an elastic element 8 is located. This is to say that the elastic element 8 is arranged between the module frame 7 and the housing 6, as shown in connection with Figure 3, wherein the first protrusion 9 and the second protrusion 11 are shown enlarged. Exemplarily, the elastic element 8 is arranged between the bottom surface 20 of the second protrusion and the top surface 19 of the first protrusion. Such an elastic element 8 provides a force in vertical direction such that the housing 6 is pushed in vertical direction to the emitter cover 16. Exemplarily, the elastic element 8 is partially compressed by the housing 6 such that it can exert the vertical force as a reaction to its compression. Due such an elastic element 8, a freedom of movement of the submodule 2 is reduced within the module frame 7 in vertical direction. The force of the elastic element in vertical direction is, e.g., not used to increase an electrically conductive connection between the press pin 4 and the emitter cover 16.

Further, the elastic element 8 is arranged between the side surface of the second protrusion 11 and the inner surface of the module frame 7. Due to such an elastic element 8, a freedom of movement of the submodule 2 is reduced within the module frame 7 in lateral directions. Due to the elastic element 8 a freedom of movement of the submodule 2 is reduced within the module frame 7 in vertical direction as well as in lateral directions, in the case the power semiconductor module 1 is in an unclamped state.

The module frame 7 shown in Figure 2 comprises six openings 13 being spaced apart from one another in lateral directions. The openings 13 are separated by material of the module frame 7. Exemplarily, the openings 13 are separated by the first protrusion 9. This is to say that between directly adjacent openings 13, the first protrusion 9 is arranged. The first protrusion 9 defines lateral extension of each opening 13.

If the power semiconductor module 1 comprises a plurality of submodules 2, each submodule 2 is arranged in one of the openings 13. Each opening 13 is configured to receive exactly one of the submodules 2.

In accordance with the claimed invention, the elastic element 8 surrounds the openings 13, and thus the submodules 2, in lateral directions, as shown in connection with the two openings 13 on the right hand side, i.e. a right region, in Figure 2. In the right region, each opening 13 is completely enclosed in lateral directions with the elastic element 8. Further, in this region, the elastic element 8 is arranged continuously on the top surface of the first protrusion 19.

This is to say that the elastic element 8 encloses the power semiconductor module 1 in lateral directions completely. For example, the elastic element 8 is arranged on the top surface of the first protrusion 19 continuously.

In connection with the two openings 13 on the left hand side, i.e. a left region, in Figure 2, the elastic element 8 surrounds the openings 13 in regions in lateral directions. In this example not falling under the claimed invention, but helpful for understanding, the openings 13 have a rectangular form and thus comprise four corner regions. In the left region, the elastic element 8 is solely arranged in the corner regions of the opening 13, e.g., in all corner regions of the opening 13. Regions between corner regions of the opening 13 are free of the elastic element 8. This is to say that the elastic element 8 is arranged on the top surface of the first protrusion 19 discontinuously.

As shown in connection with the two openings 13 in the center, i.e. a center region, in Figure 2, the elastic element 8 surrounds the openings 13 solely in regions in lateral directions.

### List of reference symbols

- 1: power semiconductor module
- 2: submodule
- 3: power semiconductor device
- 4: press pin
- 5: gate pin
- 6: housing
- 7: module frame
- 8: elastic element
- 9: first protrusion
- 10: inner side surface
- 11: second protrusion
- 12: outer side surface
- 13: opening
- 14: upper part
- 15: lower part
- 16: emitter cover
- 17: base plate
- 18: spring washer pack
- 19: top surface of the first protrusion
- 20: bottom surface of the second protrusion
- 21: gap

## Claims

1. A power semiconductor module (1), comprising:
- at least one submodule (2) including
- at least one power semiconductor device (3), wherein
said at least one power semiconductor device (3)
is connected to at least one press pin (4) and at least one gate pin (5),
- the at least one press pin (4) comprises an upper part (14) and a lower part (15),
- the lower part (15) is in direct contact to the at least one power semiconductor device (3),
- the press pin (4) comprises a spring washer pack (18) being configured to apply a force between the upper part and the lower part, pushing them in opposite directions, and
- a housing (6) laterally surrounding the at least one power semiconductor device (3), the at least one press pin (4) and the at least one gate pin (5) in lateral directions,
- a module frame (7) laterally surrounding the at least one submodule (2) in lateral directions, wherein
- at least one elastic element (8) is arranged between the module frame (7) and the housing (6),
- the module frame (7) comprises a first protrusion (9) on an inner side surface (10) facing the at least one submodule (2),
- the elastic element (8) is arranged on the first protrusion (9),
- the housing (6) comprises a second protrusion (11) on an outer side surface (12) facing the module frame (7),
- the second protrusion (11) is arranged on the elastic element (8), and
- the elastic element (8) is continuously arranged between the module frame (7) and the housing (6) and such that, due to the elastic element (8), a freedom of movement of the submodule (2) is reduced within the module frame (7) in vertical direction and lateral direction.

2. The power semiconductor module (1) according to the preceding claim, comprising at least two submodules (2), wherein
- the module frame (7) comprises at least two openings (13) being spaced apart from one another in lateral directions, and
- each submodule (2) is arranged in one of the at least two openings (13).

3. The power semiconductor module (1) according to any of the preceding claims, wherein an emitter cover (16) is arranged on the upper part (14) of the at least one press pin (4) and the module frame (7).

4. The power semiconductor module (1) according to any of the preceding claims, wherein
- a base plate (17) is arranged on the at least one power semiconductor device (3) and the housing (6), and
- the base plate (17) is in direct contact to the at least one power semiconductor device (3).

5. The power semiconductor module (1) according to any of the preceding claims, wherein the elastic element (8) is a foam.

6. The power semiconductor module (1) according to any of the preceding claims, wherein the elastic element (8) is partially compressed by the housing (6).

7. A power semiconductor assembly comprising at least two power semiconductor modules (1) according to any of the preceding claims, wherein the at least two power semiconductor modules (1) are stacked above one another.

8. A method for producing a power semiconductor module (1), the method comprising:
- providing at least one submodule (2) including
- at least one power semiconductor device (3) being connected to at least one press pin (4) and at least one gate pin (5),
- the at least one press pin (4) comprises an upper part (14) and a lower part (15),
- the lower part (15) is in direct contact to the at least one power semiconductor device (3),
- the press pin comprises a spring washer pack (18) being configured to apply a force between the upper part and the lower part, pushing them in opposite directions, and
- a housing (6) laterally surrounding the at least one power semiconductor device (3), the at least one press pin (4) and the at least one gate pin (5) in lateral directions,
- providing a module frame (7) comprising at least one opening (13),
- applying an elastic element (8) on the module frame (7) in the at least one opening (13),
- inserting the at least one submodule (2) in the at least one opening (13) of the module frame (7) on the elastic element (8), wherein
- the module frame (7) comprises a first protrusion (9) on an inner side surface (10) facing the at least one submodule (2),
- the elastic element (8) is arranged on the first protrusion (9),
- the housing (6) comprises a second protrusion (11) on an outer side surface (12) facing the module frame (7),
- the second protrusion (11) is arranged on the elastic element (8), and
- the elastic element (8) is continuously arranged between the module frame (7) and the housing (6) and such that, due to the elastic element (8), a freedom of movement of the submodule (2) is reduced within the module frame (7) in vertical direction and lateral direction.

9. The method according to claim 8 comprises at least one of
- attaching the elastic element (8) to the module frame (7) by a first adhesive, and
- attaching the at least one submodule (2) to the elastic element (8) by a second adhesive.

10. The method according to claim 8 comprises, applying the elastic element (8) directly to the module frame (7).

## Patentansprüche

1. Leistungshalbleitermodul (1), umfassend:
- mindestens ein Untermodul (2), umfassend
- mindestens eine Leistungshalbleitervorrichtung (3), wobei
die mindestens eine Leistungshalbleitervorrichtung (3) mit mindestens einem Pressstift (4) und mindestens einem Gatestift (5) verbunden ist,
- der mindestens eine Pressstift (4) einen oberen Teil (14) und einen unteren Teil (15) umfasst,
- der untere Teil (15) in direktem Kontakt mit der mindestens einen Leistungshalbleitervorrichtung (3) ist,
- der Pressstift (4) ein Tellerfederpaket (18) umfasst, das dazu ausgelegt ist, eine Kraft zwischen dem oberen Teil und dem unteren Teil aufzubringen, die diese in entgegengesetzte Richtungen drückt, und
- ein Gehäuse (6), das die mindestens eine Leistungshalbleitervorrichtung (3), den mindestens einen Pressstift (4) und den mindestens einen Gatestift (5) in lateralen Richtungen umgibt,
- einen Modulrahmen (7), der das mindestens eine Untermodul (2) in lateralen Richtungen umgibt,
wobei
- mindestens ein elastisches Element (8) zwischen dem Modulrahmen (7) und dem Gehäuse (6) angeordnet ist,
- der Modulrahmen (7) einen ersten Vorsprung (9) auf einer Innenseitenfläche (10) umfasst, die dem mindestens einen Untermodul (2) zugewandt ist,
- das elastische Element (8) auf dem ersten Vorsprung (9) angeordnet ist,
- das Gehäuse (6) einen zweiten Vorsprung (11) auf einer Außenseitenfläche (12) umfasst, die dem Modulrahmen (7) zugewandt ist,
- der zweite Vorsprung (11) auf dem elastischen Element (8) angeordnet ist, und
- das elastische Element (8) durchgehend zwischen dem Modulrahmen (7) und dem Gehäuse (6) und derart angeordnet ist, dass aufgrund des elastischen Elements (8) eine Bewegungsfreiheit des Untermoduls (2) in dem Modulrahmen (7) in vertikaler Richtung und lateraler Richtung verringert ist.

2. Leistungshalbleitermodul (1) nach dem vorhergehenden Anspruch, umfassend mindestens zwei Untermodule (2), wobei
- der Modulrahmen (7) mindestens zwei Öffnungen (13) umfasst, die in lateralen Richtungen voneinander beabstandet sind, und
- jedes Untermodul (2) in einer der mindestens zwei Öffnungen (13) angeordnet ist.

3. Leistungshalbleitermodul (1) nach einem der vorhergehenden Ansprüche, wobei eine Emitterabdeckung (16) auf dem oberen Teil (14) des mindestens einen Pressstifts (4) und dem Modulrahmen (7) angeordnet ist.

4. Leistungshalbleitermodul (1) nach einem der vorhergehenden Ansprüche, wobei
- eine Grundplatte (17) auf der mindestens einen Leistungshalbleitervorrichtung (3) und dem Gehäuse (6) angeordnet ist, und
- die Grundplatte (17) in direktem Kontakt mit der mindestens einen Leistungshalbleitervorrichtung (3) ist.

5. Leistungshalbleitermodul (1) nach einem der vorhergehenden Ansprüche, wobei das elastische Element (8) ein Schaum ist.

6. Leistungshalbleitermodul (1) nach einem der vorhergehenden Ansprüche, wobei das elastische Element (8) teilweise durch das Gehäuse (6) zusammengedrückt ist.

7. Leistungshalbleiteranordnung, umfassend mindestens zwei Leistungshalbleitermodule (1) nach einem der vorhergehenden Ansprüche, wobei die mindestens zwei Leistungshalbleitermodule (1) übereinandergestapelt sind.

8. Verfahren zum Herstellen eines Leistungshalbleitermoduls (1), wobei das Verfahren Folgendes umfasst:
- Bereitstellen mindestens eines Untermoduls (2), umfassend
- mindestens eine Leistungshalbleitervorrichtung (3), die mit mindestens einem Pressstift (4) und mindestens einem Gatestift (5) verbunden ist,
- wobei der mindestens eine Pressstift (4) einen oberen Teil (14) und einen unteren Teil (15) umfasst,
- wobei der untere Teil (15) in direktem Kontakt mit der mindestens einen Leistungshalbleitervorrichtung (3) ist,
- wobei der Pressstift ein Tellerfederpaket (18) umfasst, das dazu ausgelegt ist, eine Kraft zwischen dem oberen Teil und dem unteren Teil aufzubringen, die diese in entgegengesetzte Richtungen drückt, und
- ein Gehäuse (6), das die mindestens eine Leistungshalbleitervorrichtung (3), den mindestens einen Pressstift (4) und den mindestens einen Gatestift (5) in lateralen Richtungen umgibt,
- Bereitstellen eines Modulrahmens (7), der mindestens eine Öffnung (13) umfasst,
- Aufbringen eines elastischen Elements (8) auf den Modulrahmen (7) in der mindestens einen Öffnung (13),
- Einsetzen des mindestens einen Untermoduls (2) in die mindestens eine Öffnung (13) des Modulrahmens (7) auf das elastische Element (8), wobei
- der Modulrahmen (7) einen ersten Vorsprung (9) auf einer Innenseitenfläche (10) umfasst, die dem mindestens einen Untermodul (2) zugewandt ist,
- das elastische Element (8) auf dem ersten Vorsprung (9) angeordnet ist,
- das Gehäuse (6) einen zweiten Vorsprung (11) auf einer Außenseitenfläche (12) umfasst, die dem Modulrahmen (7) zugewandt ist,
- der zweite Vorsprung (11) auf dem elastischen Element (8) angeordnet ist, und
- das elastische Element (8) durchgehend zwischen dem Modulrahmen (7) und dem Gehäuse (6) und derart angeordnet ist, dass aufgrund des elastischen Elements (8) eine Bewegungsfreiheit des Untermoduls (2) in dem Modulrahmen (7) in vertikaler Richtung und lateraler Richtung verringert ist.

9. Verfahren nach Anspruch 8, das mindestens eines von Folgendem umfasst
- Anbringen des elastischen Elements (8) an dem Modulrahmen (7) durch einen ersten Klebstoff, und
- Anbringen des mindestens einen Untermoduls (2) an dem elastischen Element (8) durch einen zweiten Klebstoff.

10. Verfahren nach Anspruch 8, das Aufbringen des elastischen Elements (8) direkt auf den Modulrahmen (7) umfasst.

## Revendications

1. Module semi-conducteur de puissance (1), comprenant :
au moins un sous-module (2) comprenant
au moins un dispositif semi-conducteur de puissance (3), dans lequel ledit au moins un dispositif semi-conducteur de puissance (3) est connecté à au moins une broche à pression (4) et au moins un obturateur (5),
l'au moins une broche à pression (4) comprend une partie supérieure (14) et une partie inférieure (15),
la partie inférieure (15) est en contact direct avec l'au moins un dispositif semi-conducteur de puissance (3),
la broche à pression (4) comprend un ensemble de rondelles élastiques (18) conçu pour appliquer une force entre la partie supérieure et la partie inférieure, en les poussant dans des directions opposées, et
un boîtier (6) entourant latéralement l'au moins un dispositif semi-conducteur de puissance (3), l'au moins une broche à pression (4) et l'au moins un obturateur (5) dans des directions latérales,
un châssis de module (7) entourant latéralement l'au moins un sous-module (2) dans des directions latérales, dans lequel au moins un élément élastique (8) est disposé entre le châssis de module (7) et le boîtier (6),
le châssis de module (7) comprend une première saillie (9) sur une surface latérale interne (10) faisant face à l'au moins un sous-module (2),
l'élément élastique (8) est disposé sur la première saillie (9),
le boîtier (6) comprend une seconde saillie (11) sur une surface latérale externe (12) faisant face au châssis de module (7),
la seconde saillie (11) est disposée sur l'élément élastique (8), et
l'élément élastique (8) est disposé de manière continue entre le châssis de module (7) et le boîtier (6) et de façon que, grâce à l'élément élastique (8), une liberté de mouvement du sous-module (2) soit réduite à l'intérieur du châssis de module (7) dans la direction verticale et la direction latérale.

2. Module semi-conducteur de puissance (1) selon la revendication précédente, comprenant au moins deux sous-modules (2), dans lequel
le châssis de module (7) comprend au moins deux ouvertures (13) espacées l'une de l'autre dans des directions latérales, et
chaque sous-module (2) est disposé dans l'une des au moins deux ouvertures (13).

3. Module semi-conducteur de puissance (1) selon l'une quelconque des revendications précédentes, dans lequel un couvercle émetteur (16) est disposé sur la partie supérieure (14) de l'au moins une broche à pression (4) et du châssis de module (7).

4. Module semi-conducteur de puissance (1) selon l'une quelconque des revendications précédentes, dans lequel
une plaque de base (17) est disposée sur l'au moins un dispositif semi-conducteur de puissance (3) et le boîtier (6), et
la plaque de base (17) est en contact direct avec l'au moins un dispositif semi-conducteur de puissance (3).

5. Module semi-conducteur de puissance (1) selon l'une quelconque des revendications précédentes, dans lequel l'élément élastique (8) est une mousse.

6. Module semi-conducteur de puissance (1) selon l'une quelconque des revendications précédentes, dans lequel l'élément élastique (8) est partiellement comprimé par le boîtier (6).

7. Ensemble semi-conducteur de puissance comprenant au moins deux modules semi-conducteurs de puissance (1) selon l'une quelconque des revendications précédentes, dans lequel les au moins deux modules semi-conducteurs de puissance (1) sont empilés l'un au-dessus de l'autre.

8. Procédé de production d'un module semi-conducteur de puissance (1), le procédé comprenant :
la fourniture d'au moins un sous-module (2) comprenant au moins un dispositif semi-conducteur de puissance (3) connecté à au moins une broche à pression (4) et au moins un obturateur (5), l'au moins une broche à pression (4) comprend une partie supérieure (14) et une partie inférieure (15),
la partie inférieure (15) est en contact direct avec l'au moins un dispositif semi-conducteur de puissance (3),
la broche à pression comprend un ensemble de rondelles élastiques (18) conçu pour appliquer une force entre la partie supérieure et la partie inférieure, en les poussant dans des directions opposées, et
un boîtier (6) entourant latéralement l'au moins un dispositif semi-conducteur de puissance (3), l'au moins une broche à pression (4) et l'au moins un obturateur (5) dans des directions latérales,
la fourniture d'un châssis de module (7) comprenant au moins une ouverture (13),
l'application d'un élément élastique (8) sur le châssis de module (7) dans l'au moins une ouverture (13),
l'insertion de l'au moins un sous-module (2) dans l'au moins une ouverture (13) du châssis de module (7) sur l'élément élastique (8), dans lequel
le châssis de module (7) comprend une première saillie (9) sur une surface latérale interne (10) faisant face à l'au moins un sous-module (2),
l'élément élastique (8) est disposé sur la première saillie (9),
le boîtier (6) comprend une seconde saillie (11) sur une surface latérale externe (12) faisant face au châssis de module (7),
la seconde saillie (11) est disposée sur l'élément élastique (8), et
l'élément élastique (8) est disposé de manière continue entre le châssis de module (7) et le boîtier (6) et de façon que, grâce à l'élément élastique (8), une liberté de mouvement du sous-module (2) soit réduite à l'intérieur du châssis de module (7) dans la direction verticale et la direction latérale.

9. Procédé selon la revendication 8, comprenant au moins l'une des actions suivantes :
la fixation de l'élément élastique (8) au châssis de module (7) par un premier adhésif, et
la fixation de l'au moins un sous-module (2) à l'élément élastique (8) par un second adhésif.

10. Procédé selon la revendication 8, comprenant l'application de l'élément élastique (8) directement sur le châssis de module (7).
